# EUROPEAN PATENT APPLICATION

(11) **EP 4 440 259 A1**
(43) Date of publication of application: **02.10.2024**
(21) Application number: 23884182.9
(22) Date of filing: 13.06.2023
(51) Int. Cl.: H05K 7/02

(54) **ELECTRONIC ASSEMBLY AND TERMINAL DEVICE**

(30) Priority: 31.10.2022 CN 202222917215 U
(71) Applicant: Honor Device Co., Ltd., Shenzhen, Guangdong 518040 (CN)
(72) Inventor: LI, Zhengyi, Shenzhen, Guangdong 518040 (CN); ZONG, Xianbo, Shenzhen, Guangdong 518040 (CN); YANG, Xinrong, Shenzhen, Guangdong 518040 (CN)
(74) Representative: Gill Jennings & Every LLP
(86) International application number: PCT/CN2023/099931
(87) International publication number: WO 2024/093243

(57) **Abstract**

This application provides an electronic assembly and a terminal device. The electronic assembly includes: a first component; a second component, forming accommodation space with the first component; and a connecting member, where one end of the connecting member is connected to the first component, the other end of the connecting member passes through the accommodation space to be connected to the second component, the connecting member is in a sheet shape, a surface of the connecting member having a larger area is the first surface, and a part of the first surface located in the accommodation space is attached to a wall surface of the accommodation space. Compared with the use of a radio frequency coaxial line to connect the first component and the second component in the conventional technologies, because a thickness of the sheet-shaped connecting member is small, space of the accommodation space occupied in a height direction is much smaller than space occupied in a width direction of the accommodation space in the conventional technologies. In this way, a volume of the accommodation space can be effectively increased without changing a size of a housing.

## Description

This application claims priority to Chinese Patent Application No. 202222917215.2, filed with the China National Intellectual Property Administration on October 31, 2022 and entitled "ELECTRONIC ASSEMBLY AND TERMINAL DEVICE", which is incorporated herein by reference in its entirety.

### TECHNICAL FIELD

This application relates to the field of electronic devices, and in particular, to an electronic assembly and a terminal device.

### BACKGROUND

A plurality of terminal devices need to send and receive signals. The terminal device that needs to send and receive signals usually uses an antenna spring to connect an antenna module and a transmission link on a structural member. In the related art, a radio frequency coaxial line is usually used to connect the antenna spring and a main board to transmit signals between the antenna spring and the main board. The radio frequency coaxial line is usually extended attached to a frame. Because the radio frequency coaxial line is cylindrical and has a large diameter, the radio frequency coaxial line occupies large space. For example, in a position close to a battery compartment, the radio frequency coaxial line occupies too much space in the battery compartment, resulting in a difficulty to expand a volume of a battery, and restricting standby time of the entire terminal device.

### SUMMARY

This application provides an electronic assembly and a terminal device to resolve a problem that a radio frequency coaxial line in the terminal device occupies too much space in a battery compartment, resulting in a difficulty to expand a volume of a battery.

The technical solutions are as follows:
According to a first aspect, this application provides an electronic assembly, including:
a housing, forming a first side wall, a second side wall, and a bottom wall, where the first side wall, the second side wall, and the bottom wall jointly form accommodation space;
a first component, close to the first side wall;
a second component, close to the second side wall;
a connecting member, where one end of the connecting member is connected to the first component, the other end of the connecting member passes through the accommodation space to be connected to the second component, the connecting member is in a sheet shape, a surface of the connecting member having a larger area is the first surface, and a part of the first surface located in the accommodation space is attached to the bottom wall.

Compared with the use of a radio frequency coaxial line to connect the first component and the second component in the conventional technologies, the radio frequency coaxial line is cylindrical and needs to be close to the first side wall. Because the radio frequency coaxial line is wide and receiving space needs to be reserved, the accommodation space is caused to be occupied in large space in a width direction. However, the connecting member provided in this application is in a sheet shape, and the connecting member may be attached to the bottom wall without being close to the first side wall. Therefore, the space in the width direction of the accommodation space is not be occupied, but only in a height direction of the accommodation space. In addition, because a thickness of the sheet-shaped connecting member is small, space of the accommodation space occupied in a height direction is much smaller than space occupied in a width direction of the accommodation space in the conventional technologies. In this way, a volume of the accommodation space can be effectively increased without changing a size of a housing.

In some implementations, a part that is of the connecting member and that is located in the accommodation space is a flexible printed circuit board. The flexible printed circuit board forms the first surface.

The flexible printed circuit board has characteristics of a small thickness and a stable structure. Therefore, it can be ensured that the flexible printed circuit board occupies a small volume of the accommodation space and stably transmits an electrical signal between the first component and the second component.

In some implementations, the flexible printed circuit board at least partially forms a coplanar waveguide.

The coplanar waveguide has a characteristic of a small thickness, facilitating reducing occupation of space by the flexible printed circuit board in the height direction of the accommodation space. For a radio frequency signal, the use of the coplanar waveguide for transmission can effectively reduce insertion loss to ensure a transmission effect of the radio frequency signal.

In some implementations, the flexible printed circuit board includes:
a substrate that is of a flexible structure; and
a first conducting layer, fixedly attached to a first surface of the substrate, and configured to be connected to the first component and the second component and transmit an electrical signal between the first component and the second component.

The substrate is used to provide an attachment surface so that the first conducting layer may be attached to the first surface of the substrate. The first conducting layer may be used to transmit the electrical signal between the first component and the second component. The substrate may have a small thickness and a large width. In this case, the first conducting layer may also have a small thickness and a large width to obtain a specific cross-sectional area. Therefore, the overall structure has a small thickness, occupying less space in the height direction of the accommodation space.

In some implementations, the first conducting layer includes:
a first wire, fixedly attached to the first surface of the substrate, and configured to be connected to the first component and the second component and transmit an electrical signal between the first component and the second component; and
a second wire, fixedly attached to the first surface of the substrate, and configured to be connected to the first component and the second component and form an electrical loop together with the first wire, where the second wire and the first wire are spaced apart from each other.

The first wire may be used to transmit the electrical signal between the first component and the second component, and the second wire may be used to form a complete electrical loop. Because the substrate is wide, both the first wire and the second wire may be laid flat on the first surface of the substrate, and only a single conducting layer is used to transmit the electrical signal between the first component and the second component. It can be ensured that the overall structure occupies less space in the height direction of the accommodation space.

In some implementations, the flexible printed circuit board further includes:
a first protective film, fixedly attached to a surface of the first conducting layer facing away from the substrate, and covering the first conducting layer.

Using the first protective film to protect the first conducting layer can prevent the first conducting layer from suffering a risk of open circuit due to damage, and can further prevent the first conducting layer from directly contacting other structures during operation, thereby preventing a risk of short circuit in the first conducting layer.

In some implementations, the flexible printed circuit board further includes:
a second conducting layer, fixedly attached to a second surface of the substrate facing away from the first conducting layer, configured to be connected to the first component and the second component and form an electrical loop together with the first wire.

Using the substrate, the first conducting layer, and the second conducting layer, a microstrip may be formed at an end of the flexible printed circuit board, and the microstrip may be used to facilitate connection to the first component and the second component.

In some implementations, the second conducting layer includes:
a third wire, fixedly attached to the second surface of the substrate, disposed on one end of the flexible printed circuit board close to the first component, and configured to be connected to the first component, where the substrate has a first opening, and the third wire passes through the first opening to be connected to the second wire; and
a fourth wire, fixedly attached to the second surface of the substrate, disposed on one end of the flexible printed circuit board close to the second component, and configured to be connected to the second component, where the substrate has a second opening, and the fourth wire passes through the second opening to be connected to the second wire.

Decapping processing is performed on the second conducting layer, so that the second conducting layer only has physical structures at two ends of the flexible printed circuit board, and there is no second conducting layer in a middle region of the flexible printed circuit board. In this case, the third wire forms a ground plane of the microstrip close to one end of the first component, and the fourth wire forms a ground plane of the microstrip close to one end of the second component. While it is convenient for the flexible printed circuit board to be connected to the first component and the second component separately, functional integrity of the second conducting layer is also ensured when there are no physical structures in the middle region. Because the middle region of the flexible printed circuit board needs to pass through the accommodation space, the second conducting layer does not occupy the accommodation space when there is no second conducting layer in the middle region of the flexible printed circuit board. Therefore, the volume of the accommodation space is effectively ensured.

In some implementations, the flexible printed circuit board further includes:
a second protective film, fixedly attached to a surface of the second conducting layer facing away from the substrate, and covering the second conducting layer.

Using the second protective film to protect the second conducting layer can prevent the second conducting layer from suffering a risk of open circuit due to damage, and can further prevent the second conducting layer from directly contacting other structures during operation, thereby preventing a risk of short circuit in the second conducting layer.

In some implementations, the second protective film includes:
a first part, fixedly attached to a surface of the third wire facing away from the substrate, and covering the third wire; and
a second part, fixedly attached to a surface of the fourth wire facing away from the substrate, and covering the fourth wire.

Decapping processing is performed on the second protective film, so that the second protective film only has physical structures at the two ends of the flexible printed circuit board, and there is no second protective film in the middle region of the flexible printed circuit board. Because the second conducting layer only has the physical structures at the two ends of the flexible printed circuit board, the first part of the second protective film may be used to protect the third wire of the second conducting layer, and the second part of the second protective film may be used to protect the fourth wire of the second conducting layer, so that the second protective film can be used to protect the second conducting layer. Because the middle region of the flexible printed circuit board needs to pass through the accommodation space, the second protective film does not occupy the accommodation space when there is no second protective film in the middle region of the flexible printed circuit board. Therefore, the volume of the accommodation space is effectively ensured.

In some implementations, the flexible printed circuit board further includes:
an insulation layer, fixedly attached to a surface of the first conducting layer facing away from the substrate; and
a third conducting layer, fixedly attached to a third surface of the insulation layer facing away from the first conducting layer, configured to be connected to the first component and the second component, and forming an electrical loop together with the first wire.

The insulation layer may be used to isolate the second conducting layer and the third conducting layer, so that the second conducting layer and the third conducting layer do not interfere with each other.

Using the substrate, the first conducting layer, the second conducting layer, the insulation layer, and the third conducting layer, a strip line may be formed at an end of the flexible printed circuit board, and the strip line may be used to facilitate connection to the first component and the second component.

In some implementations, the third conducting layer includes:
a fifth wire, fixedly attached to a third surface of the insulation layer, disposed on one end of the flexible printed circuit board close to the first component, and configured to be connected to the first component, where the insulation layer has a third opening, and the fifth wire passes through the third opening to be connected to the second wire; and
a sixth wire, fixedly attached to the third surface of the insulation layer, disposed on one end of the flexible printed circuit board close to the second component, and configured to be connected to the second component, where the insulation layer has a fourth opening, and the sixth wire passes through the fourth opening to be connected to the second wire.

Decapping processing is performed on the third conducting layer, so that the third conducting layer only has physical structures at the two ends of the flexible printed circuit board, and there is no third conducting layer in the middle region of the flexible printed circuit board. In this case, the fourth wire forms a ground plane of the strip line close to one end of the first component, and the fifth wire forms a ground plane of the strip line close to one end of the second component. While it is convenient for the flexible printed circuit board to be connected to the first component and the second component separately, functional integrity of the third conducting layer is also ensured when there are no physical structures in the middle region. Because the third conducting layer does not occupy the accommodation space, the volume of the accommodation space is effectively ensured.

In some implementations, the flexible printed circuit board further includes:
a third protective film, fixedly attached to a surface of the third conducting layer facing away from the substrate, and covering the third conducting layer.

Using the third protective film to protect the third conducting layer can prevent the third conducting layer from suffering a risk of open circuit due to damage, and can further prevent the third conducting layer from directly contacting other structures during operation, thereby preventing a risk of short circuit in the third conducting layer.

In some implementations, the third protective film includes:
a third part, fixedly attached to a surface of the fifth wire facing away from the insulation layer, and covering the fifth wire; and
a fourth part, fixedly attached to a surface of the sixth wire facing away from the insulation layer, and covering the sixth wire.

Decapping processing is performed on the third protective film, so that the third protective film only has physical structures at the two ends of the flexible printed circuit board, and there is no third protective film in the middle region of the flexible printed circuit board. Because the third conducting layer only has the physical structures at the two ends of the flexible printed circuit board, the third part of the third protective film may be used to protect the fifth wire of the third conducting layer, and the fourth part of the third protective film may be used to protect the sixth wire of the third conducting layer, so that the third protective film can be used to protect the third conducting layer. Because the middle region of the flexible printed circuit board needs to pass through the accommodation space, the third protective film does not occupy the accommodation space when there is no third protective film in the middle region of the flexible printed circuit board. Therefore, the volume of the accommodation space is effectively ensured.

In some implementations, further including:
a reinforcement member that is of a rigid structure and fixedly connected to the first component and a part of the connecting member close to the first component.

At a connection part between the connecting member and the first component, due to a small thickness of the flexible printed circuit board, it is difficult to fix the flexible printed circuit board on a structure such as the housing. Consequently, the connecting member and the first component are caused to be easily disconnected by external forces such as impact. The use of reinforcement member can keep a positional relationship between the connecting member and the first component stable at the connection part, thereby improving impact resistance of the overall structure.

A second aspect of this application provides a terminal device, including the foregoing electronic assembly.

Because the foregoing electronic assembly can effectively increase the volume of the accommodation space, the terminal device can accommodate an electronic component having a larger volume without changing a size of the housing, thereby effectively improving performance of the terminal device.

In some implementations, further including:
a battery, accommodated in the accommodation space.

A surface of the connecting member facing away from the first surface is attached to the battery.

When a structure accommodated in the accommodation space is the battery, the volume of the battery can be increased without changing the size of the housing, effectively increasing standby time of the terminal device.

### BRIEF DESCRIPTION OF DRAWINGS

FIG. 1 is a top view of an electronic assembly according to an embodiment of this application;
FIG. 2 is a three-dimensional view of an electronic assembly according to an embodiment of this application;
FIG. 3 is a vertical sectional view of a single-layer flexible printed circuit board according to an embodiment of this application;
FIG. 4 is a horizontal sectional view of a single-layer flexible printed circuit board according to an embodiment of this application;
FIG. 5 is a vertical sectional view of a double-layer flexible printed circuit board according to an embodiment of this application;
FIG. 6 is a horizontal sectional view of one end of a double-layer flexible printed circuit board according to an embodiment of this application;
FIG. 7 is a horizontal sectional view of a middle region of the double-layer flexible printed circuit board according to an embodiment of this application;
FIG. 8 is a horizontal sectional view of the other end of the double-layer flexible printed circuit board according to an embodiment of this application;
FIG. 9 is a vertical sectional view of a first-type triple-layer flexible printed circuit board according to an embodiment of this application;
FIG. 10 is a horizontal sectional view of one end of the first-type triple-layer flexible printed circuit board according to an embodiment of this application;
FIG. 11 is a horizontal sectional view of a middle region of the first-type triple-layer flexible printed circuit board according to an embodiment of this application;
FIG. 12 is a horizontal sectional view of the other end of the first-type triple-layer flexible printed circuit board according to an embodiment of this application;
FIG. 13 is a vertical sectional view of a second-type triple-layer flexible printed circuit board according to an embodiment of this application;
FIG. 14 is a horizontal sectional view of one end of the second-type triple-layer flexible printed circuit board according to an embodiment of this application;
FIG. 15 is a horizontal sectional view of a middle region of the second-type triple-layer flexible printed circuit board according to an embodiment of this application;
FIG. 16 is a horizontal sectional view of the other end of the second-type triple-layer flexible printed circuit board according to an embodiment of this application;
FIG. 17 is a top view of a terminal device according to an embodiment of this application; and
FIG. 18 is a three-dimensional view of a terminal device according to an embodiment of this application.

The meanings represented by reference numerals are as follows:
100: electronic assembly; 110: housing; 111: accommodation space; 120: first component; 130: second component; 140: connecting member; 141: substrate; 1411: first opening; 1412: second opening; 142: first conducting layer; 1421: first wire; 1422: second wire; 143: first protective film; 144: second conducting layer; 1441: third wire; 1442: fourth wire; 145: second protective film; 1451: first part; 1452: second part; 146: insulation layer; 1461: third opening; 1462: fourth opening; 147: third conducting layer; 1471: fifth wire; 1472: sixth wire; 148: third protective film; 1481: third part; 1482: fourth part; 150: reinforcement member; 200: terminal device; 210: battery.

### DESCRIPTION OF EMBODIMENTS

To make the objectives, technical solutions, and advantages of this application clearer, the following further describes implementations of this application in detail with reference to the accompanying drawings.

It should be understood that the term "plurality of mentioned in this application means two or more. In descriptions of this application, unless otherwise specified, "/" means "or". For example, A/B may indicate A or B. The term "and/or" in this specification describes only an association relationship for describing an associated object and indicates that three relationships may exist. For example, A and/or B may represent the following three cases: Only A exists, both A and B exist, and only B exists. In addition, for ease of describing the technical solutions in embodiments of this application clearly, terms such as "first" and "second" are used to distinguish same or similar items with basically same functions and roles. A person skilled in the art may understand that the terms such as "first" and "second" do not limit a quantity or an execution sequence, and the terms such as "first" and "second" do not indicate a definite difference.

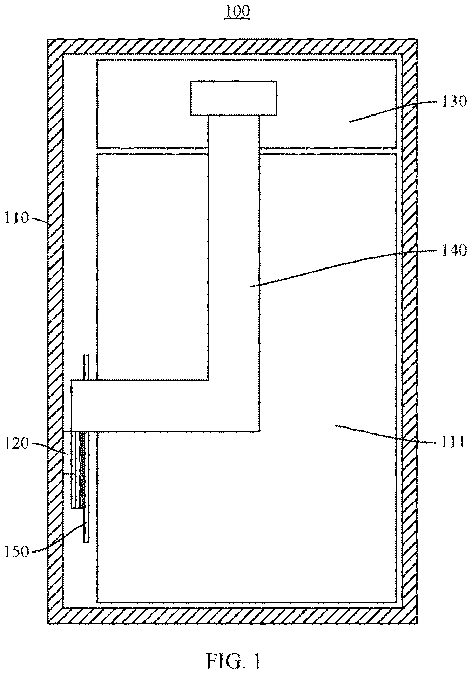

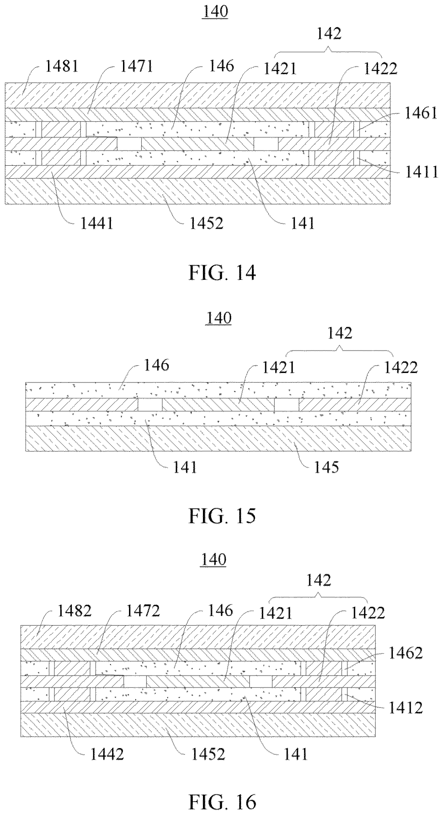

The following describes in detail an electronic assembly and a terminal device provided in embodiments of this application with reference to FIG. 1 to FIG. 18.

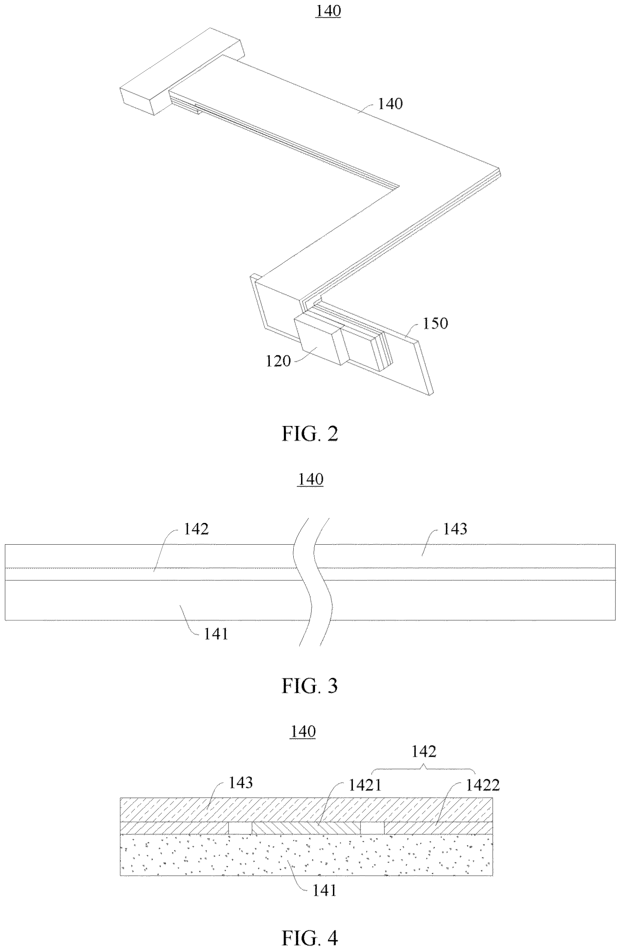

Refer to FIG. 1 and FIG. 2. In one or more embodiments, this application provides an electronic assembly 100. The electronic assembly 100 includes a housing 110, a first component 120, a second component 130, and a connecting member 140.

The housing 110 may be of a plate-shaped structure, that is, a height of the housing 110 is much smaller than a width and a length of the housing 110. Certainly, in other embodiments of this application, the housing 110 may alternatively be of a columnar structure, a spherical structure, or other structures. The shape of the housing 110 is not limited in this application. For ease of description, an example in which the housing 110 is of a plate-shaped structure is used for description in this application.

The housing 110 forms a first side wall, a second side wall, and a bottom wall. The first side wall, the second side wall, and the bottom wall jointly form accommodation space 111. The accommodation space 111 may be a recess formed by an inward recess of a part of an outer surface of the housing 110. In this case, the first side wall, the second side wall, and the bottom wall are all part of the outer surface of the housing 110. In addition, the accommodation space 111 is open space. Certainly, in other embodiments of this application, the accommodation space 111 may alternatively be a cavity formed by hollowing out an interior of the housing 110. In this case, the first side wall, the second side wall, and the bottom wall are all part of an interior surface of the housing 110. In addition, the accommodation space 111 is closed space. A formation method of the accommodation space 111 is not limited in this application. For ease of description, an example in which the accommodation space 111 is a recess is used for description in this application. In an embodiment in which the housing 110 is of the plate-shaped structure, to fit with the structure of the housing 110, the accommodation space 111 may be in a flat-rectangle shape. Certainly, in other embodiments of this application, according to a specific structure of the housing 110 and a specific usage scenario of the accommodation space 111, the accommodation space 111 may alternatively be in a columnar shape, a spherical shape, or another shape. The shape of the accommodation space 111 is not limited in this application. For ease of description, an example in which the accommodation space 111 is in a flat-rectangle shape is used for description in this application.

The first component 120 is close to the first side wall. Specifically, the first component 120 may be fixedly installed on the first side wall. To be specific, the first component 120 is attached to the first side wall. The first component 120 may alternatively be fixedly installed near the first side wall. To be specific, a gap is formed between the first component 120 and the first side wall. A specific position of the first component 120 is not limited in this application. For ease of description, an example in which the first component 120 is attached to the first side wall is used for description in this application. Specifically, the first component 120 is a conventional component forming an electronic device. For example, the first component 120 may be a component such as an antenna spring, a signal transceiver component, a switch component, a display component, a processing component, or a circuit board.

The second component 130 is close to the second side wall. Specifically, the second component 130 may be fixedly installed on the second side wall. To be specific, the second component 130 is attached to the second side wall. The second component 130 may alternatively be fixedly installed near the second side wall. To be specific, a gap is formed between the second component 130 and the second side wall. A specific position of the second component 130 is not limited in this application. For ease of description, an example in which the second component 130 is close to the second side wall is used for description in this application. Specifically, the second component 130 is also a conventional component forming an electronic device. For example, the second component 130 may be a component such as a signal transceiver component, a switch component, a display component, a processing component, or a circuit board.

When the accommodation space 111 is the flat-rectangle shape, the first side wall and the second side wall may be disposed opposite to each other. In this case, a connection between the first component 120 and the second component 130 needs to traverse the accommodation space 111. Certainly, the first side wall and the second side wall may alternatively be connected to each other. In this case, a connection between the first component 120 and the second component 130 needs to diagonally cross the accommodation space 111.

One end of the connecting member 140 is connected to the first component 120 (as shown in the left end in FIG. 1) to transmit a signal between the connecting member 140 and the first component 120. Specifically, one end of the connecting member 140 may be connected to the first component 120 through welding or other manners, or may be connected to the first component 120 through a clip or another structure. The other end of the connecting member 140 is connected to the second component 130 (as shown in the upper end in FIG. 1) to transmit a signal between the connecting member 140 and the second component 130. Specifically, the other end of the connecting member 140 may be connected to the second component 130 through welding or other manners, or may be connected to the second component 130 through a clip or another structure. The connecting member 140 is configured to transmit a signal between the first component 120 and the second component 130. Specifically, the signal transmitted by the connecting member 140 between the first component 120 and the second component 130 may be an electrical signal or other signals, such as an optical signal, that require media for transmission or media guidance. For ease of description, an example in which the signal transmitted by the connecting member 140 between the first component 120 and the second component 130 is the electrical signal is used for description in this application.

The connecting member 140 is in a sheet shape. To be specific, a thickness of the connecting member 140 is much smaller than a width and a length of the connecting member 140. Specifically, a cross section of the connecting member 140 perpendicular to a length direction may be rectangular. To be specific, the connecting member 140 may be in a rectangular shape in a lay-flat state. Certainly, a cross section of the connecting member 140 perpendicular to a length direction may alternatively be trapezoidal. To be specific, the connecting member 140 may be in a trapezoidal shape in a lay-flat state. A cross section of the connecting member 140 perpendicular to a length direction may alternatively be obround. To be specific, the connecting member 140 may be in an obround cylindrical shape in a lay-flat state. A cross section of the connecting member 140 perpendicular to a length direction may alternatively be in an elliptical shape or another shape. To be specific, the connecting member 140 may be in an elliptical cylinder shape or another shape in a lay-flat state. To have a larger volume under a same width, in this application, an example in which the cross section of the connecting member 140 perpendicular to the length direction is rectangular is used as an example. A surface of the connecting member 140 having a larger area is the first surface. Specifically, when the cross section of the connecting member 140 perpendicular to the length direction is in a rectangular shape, the first surface is a bottom surface or a top surface of the connecting member 140. In this application, an example in which the first surface is the bottom surface is used as an example for description.

A part of the first surface located in the accommodation space 111 is attached to the bottom wall of the housing 110. When a structure of the first component 120 is located in the accommodation space 111 and joints of the second component 130 are also located in the accommodation space 111, the connecting member 140 may all be located in the accommodation space 111. At this time, the entire first surface is located in the accommodation space 111. Therefore, the entire first surface is attached to the bottom wall of the housing 110 at this time. Certainly, in some embodiments, a part of the connecting member 140 may pass through the accommodation space 111. In this case, a part of the first surface is located outside the accommodation space 111. At this time, a part of the first surface located within the accommodation space 111 is entirely attached to the bottom wall of the housing 110. Specifically, to cause the first surface attached to the bottom wall of the housing 110, the connecting member 140 and the housing 110 may be bonded by using glue, engaging a clip, a manner that the structure in the accommodation space 111 squeezes the connecting member 140 after assembly is completed, or the like. In this application, a specific connection manner between the connecting member 140 and the housing 110 is not limited.

Compared with the use of a radio frequency coaxial line to connect the first component 120 and the second component 130 in the conventional technologies, the radio frequency coaxial line is cylindrical and needs to be close to the first side wall. Because the radio frequency coaxial line is wide and receiving space needs to be reserved, the accommodation space 111 is caused to be occupied in large space in a width direction. However, the connecting member 140 provided in this application is in a sheet shape, and the connecting member may be attached to the bottom wall without being close to the first side wall. Therefore, the space in the width direction of the accommodation space 111 is not be occupied, but only in a height direction of the accommodation space 111. In addition, because a thickness of the sheet-shaped connecting member 140 is small, space of the accommodation space 111 occupied in a height direction is much smaller than space occupied in a width direction of the accommodation space 111 in the conventional technologies. In this way, a volume of the accommodation space 111 can be effectively increased without changing a size of a housing 110.

As shown in FIG. 1 and FIG. 2, in one or more embodiments, at least part of the connecting member 140 is a flexible printed circuit board. It should be noted that the connecting member 140 may be entirely a flexible printed circuit board, or may be partially a flexible printed circuit board. In a specific embodiment of this application, that the entire connecting member 140 is a flexible printed circuit board is described.

The flexible printed circuit board is of a sheet structure, and the flexible printed circuit board has two surfaces with a largest area. The two surfaces with a largest area are a bottom surface and a top surface that are disposed opposite to each other. Both the bottom surface and the top surface may be the first surface. Specifically, the first surface may be entirely formed by one of the bottom surface and the top surface. For example, when the entire flexible printed circuit board is in a lay-flat state, the first surface may be entirely formed by the bottom surface. Certainly, the first surface may alternatively be partially formed by the bottom surface, and the other part of the first surface is formed by the top surface. For example, when a specific position of the flexible printed circuit board is bent, a part of the first surface before bending may be formed by the bottom surface, and a part of the first surface after bending may be formed by the top surface.

The flexible printed circuit board has characteristics of a small thickness and a stable structure. Therefore, it can be ensured that the flexible printed circuit board occupies a small volume of the accommodation space 111 and stably transmits an electrical signal between the first component 120 and the second component 130.

In this application, there may be one, two, three, or more conducting layers in the flexible printed circuit board. Cases in which a quantity of the conducting layers in the flexible printed circuit board is one, two, and three are explained separately in the following.

As shown in FIG. 3 and FIG. 4, when there is one conducting layer in the flexible printed circuit board, the flexible printed circuit board includes a substrate 141 and a first conducting layer 142.

The substrate 141 is of a flexible structure. Specifically, the substrate 141 may be of a thin sheet-like flexible structure formed of a polyimide film or a polyester film. The substrate 141 may withstand relatively large deformations. For example, bending, folding, and other processing may be performed on the substrate 141.

The first conducting layer 142 is fixedly attached to a first surface of the substrate 141. The first conducting layer 142 is configured to be connected to the first component 120 and the second component 130 and transmit an electrical signal between the first component 120 and the second component 130. The first conducting layer 142 may be made of at least one of conductive metals such as copper, silver, and gold, to transmit an electrical signal. Specifically, the first conducting layer 142 may be fixedly attached to the first surface of the substrate 141 through electroplating or other manners. The first conducting layer 142 may form a circuit through etching or other manners. Because a thickness of the first conducting layer 142 is small in the flexible printed circuit board, specifically, the thickness of the first conducting layer 142 may be 8 µm to 20 µm, and the conductive metals such as copper, silver, and gold have good ductility, the entire flexible printed circuit board formed by the substrate 141 and the first conducting layer 142 may also withstand relatively large deformations. For example, bending, folding, and other processing may be performed on the flexible printed circuit board.

The substrate 141 is used to provide an attachment surface so that the first conducting layer 142 may be attached to the first surface of the substrate 141. The first conducting layer 142 may be used to transmit the electrical signal between the first component 120 and the second component 130. The substrate 141 may have a small thickness and a large width. In this case, the first conducting layer 142 may also have a small thickness and a large width to obtain a specific cross-sectional area. Therefore, the overall structure has a small thickness, occupying less space in the height direction of the accommodation space 111.

As shown in FIG. 3 and FIG. 4, in one or more embodiments, the first conducting layer 142 includes a first wire 1421 and a second wire 1422.

The first wire 1421 is fixedly attached to the first surface of the substrate 141. Specifically, the first wire 1421 may be formed by etching the first conducting layer 142. The first wire 1421 is configured to be connected to the first component 120 and the second component 130 and transmit an electrical signal between the first component 120 and the second component 130. Therefore, the first wire 1421 is in a strip shape, and the first wire 1421 is continuous without interruption between the first component 120 and the second component 130 to ensure that the first wire 1421 may transmit the electrical signal between the first component 120 and the second component 130.

The second wire 1422 is fixedly attached to the first surface of the substrate 141. Specifically, the second wire 1422 may be formed by etching the first conducting layer 142. The second wire 1422 is configured to be connected to the first component 120 and the second component 130 and form an electrical loop together with the first wire 1421. Therefore, the second wire 1422 is in a strip shape, and the second wire 1422 is continuous without interruption between the first component 120 and the second component 130 to ensure that the second wire 1422 may form an electrical loop between the first component 120 and the second component 130 together with the first wire 1421. The second wire 1422 and the first wire 1421 are spaced apart from each other. To be specific, the first wire 1421 and the second wire 1422 are not in direct contact, to prevent a risk of short circuit between the first wire 1421 and the second wire 1422.

The first wire 1421 may be used to transmit the electrical signal between the first component 120 and the second component 130, and the second wire 1422 may be used to form a complete electrical loop. Because the substrate 141 is wide, both the first wire 1421 and the second wire 1422 may be laid flat on the first surface of the substrate 141, and only a single conducting layer is used to transmit the electrical signal between the first component 120 and the second component 130. It can be ensured that the overall structure occupies less space in the height direction of the accommodation space 111.

As shown in FIG. 3 and FIG. 4, in one or more embodiments, the flexible printed circuit board may further include a first protective film 143.

The first protective film 143 may be of a thin sheet-like flexible structure formed of a plastic film. The first protective film 143 is fixedly attached to a surface of the first conducting layer 142 facing away from the substrate 141 and covers the first conducting layer 142. In other words, the entire first conducting layer 142 is located in clamping space formed by the substrate 141 and the first protective film 143. The first protective film 143 may be used to effectively protect the first conducting layer 142 to prevent the first conducting layer 142 from being damaged and causing an open circuit in some regions. Because the first protective film 143 is also of a thin sheet-like flexible structure, presence of the first protective film 143 does not affect bending, folding, and other processing on the flexible printed circuit board.

Using the first protective film 143 to protect the first conducting layer 142 can prevent the first conducting layer 142 from suffering a risk of open circuit due to damage, and can further prevent the first conducting layer 142 from directly contacting other structures during operation, thereby preventing a risk of short circuit in the first conducting layer 142.

As shown in FIG. 3 and FIG. 4, when there is one conducting layer in the flexible printed circuit board, a thickness of the substrate 141 may be 30 µm to 70 µm. For example, the thickness of the substrate 141 may be 50 µm. The thickness of the first conducting layer 142 may be 8 µm to 20 µm. For example, the thickness of the first conducting layer 142 may be 12 µm. A thickness of the first protective film 143 may be 20 µm to 50 µm. For example, the thickness of the first protective film 143 may be 27.5 µm. In conclusion, a thickness of the entire flexible printed circuit board may be 70 µm to 130 µm. For example, the thickness of the entire flexible printed circuit board may be 89.5 µm. In this case, the flexible printed circuit board only occupies a height of the accommodation space 111 by 89.5 µm, while a radio frequency coaxial line used in the conventional technologies needs to occupy a width of the accommodation space 111 by about 1000 µm. In a mobile phone with a general size, when the accommodation space 111 is used for placing a battery 210, according to the solution of this application, capacity of the battery 210 can be increased by 30 mAh to 60 mAh. Specifically, undergoing many tests, when a size of the mobile phone is 6 inches, increased capacity of the battery 210 is about 40 mAh.

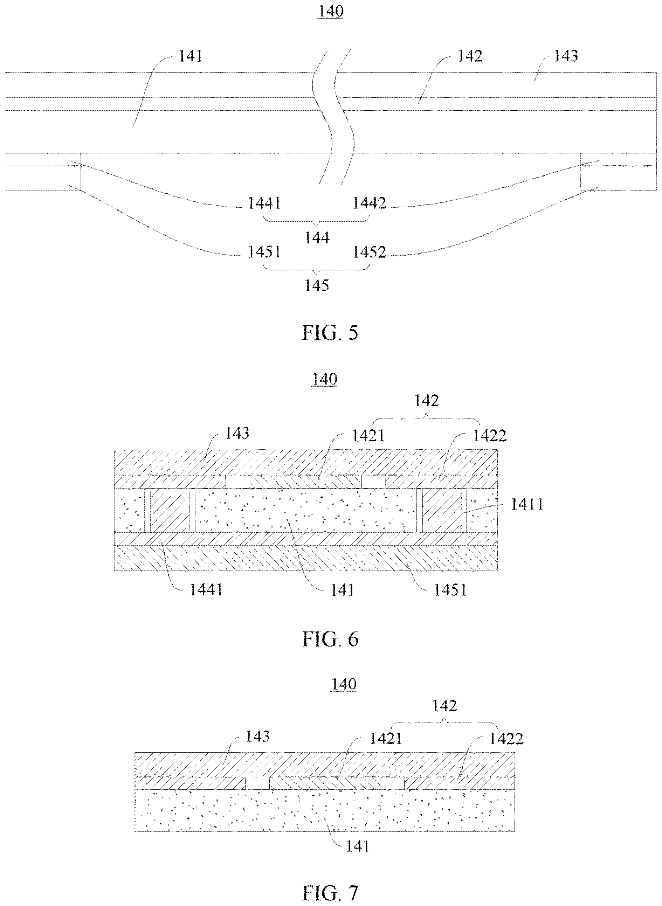

As shown in FIG. 5, when there are two conducting layers in the flexible printed circuit board, the flexible printed circuit board includes a substrate 141, a first conducting layer 142, and a second conducting layer 144.

The substrate 141 is of a flexible structure. Specifically, the substrate 141 may be of a thin sheet-like flexible structure formed of a polyimide film or a polyester film. The substrate 141 may withstand relatively large deformations. For example, bending, folding, and other processing may be performed on the substrate 141.

The first conducting layer 142 is fixedly attached to a first surface of the substrate 141. The first conducting layer 142 is configured to be connected to the first component 120 and the second component 130 and transmit an electrical signal between the first component 120 and the second component 130. The first conducting layer 142 may be made of at least one of conductive metals such as copper, silver, and gold, to transmit an electrical signal. Specifically, the first conducting layer 142 may be fixedly attached to the first surface of the substrate 141 through electroplating or other manners. The first conducting layer 142 may form a circuit through etching or other manners. Because a thickness of the first conducting layer 142 is small in the flexible printed circuit board, specifically, the thickness of the first conducting layer 142 may be 8 µm to 20 µm, and the conductive metals such as copper, silver, and gold have good ductility, the entire flexible printed circuit board formed by the substrate 141 and the first conducting layer 142 may also withstand relatively large deformations. For example, bending, folding, and other processing may be performed on the flexible printed circuit board.

The second conducting layer 144 is fixedly attached to a second surface of the substrate 141. To be specific, the second conducting layer 144 is fixedly attached to a surface of the substrate 141 facing away from the first conducting layer 142. The second conducting layer 144 is configured to be connected to the first component 120 and the second component 130 and form an electrical loop together with the first wire 1421. The second conducting layer 144 may be made of at least one of conductive metals such as copper, silver, and gold, to form an electrical loop together with the first wire 1421. Specifically, the second conducting layer 144 may be fixedly attached to the second surface of the substrate 141 through electroplating or other manners. The second conducting layer 144 may form a circuit through etching or other manners. Because a thickness of the second conducting layer 144 is small in the flexible printed circuit board, specifically, the thickness of the second conducting layer 144 may be 8 µm to 20 µm, and the conductive metals such as copper, silver, and gold have good ductility, the entire flexible printed circuit board formed by the substrate 141, the first conducting layer 142, and the second conducting layer 144 may also withstand relatively large deformations. For example, bending, folding, and other processing may be performed on the flexible printed circuit board.

Using the substrate 141, the first conducting layer 142, and the second conducting layer 144, a microstrip may be formed at an end of the flexible printed circuit board. The first component 120 and the second component 130 in the conventional technologies are generally configured to be connected to a radio frequency coaxial line. The first component 120 and the second component 130 are adaptively modified with respect to the radio frequency coaxial line, and consequently, the first component 120 and the second component 130 are not convenient to be directly connected to a coplanar waveguide. Forming microstrips at two ends of the coplanar waveguide can facilitate connection to the first component 120 and the second component 130.

As shown in FIG. 6, FIG. 7, and FIG. 8, in one or more embodiments, the first conducting layer 142 includes a first wire 1421 and a second wire 1422.

The first wire 1421 is fixedly attached to the first surface of the substrate 141. Specifically, the first wire 1421 may be formed by etching the first conducting layer 142. The first wire 1421 is configured to be connected to the first component 120 and the second component 130 and transmit an electrical signal between the first component 120 and the second component 130. Therefore, the first wire 1421 is in a strip shape, and the first wire 1421 is continuous without interruption between the first component 120 and the second component 130 to ensure that the first wire 1421 may transmit the electrical signal between the first component 120 and the second component 130. Specifically, the first wire 1421 forms a signal line in the microstrip at an end of the flexible printed circuit board close to the first component 120.

The second wire 1422 is fixedly attached to the first surface of the substrate 141. Specifically, the second wire 1422 may be formed by etching the first conducting layer 142. The second wire 1422 is configured to be connected to the first component 120 and the second component 130 and form an electrical loop together with the first wire 1421. Therefore, the second wire 1422 is in a strip shape, and the second wire 1422 is continuous without interruption between the first component 120 and the second component 130 to ensure that the second wire 1422 may form an electrical loop between the first component 120 and the second component 130 together with the first wire 1421. The second wire 1422 and the first wire 1421 are spaced apart from each other. To be specific, the first wire 1421 and the second wire 1422 are not in direct contact, to prevent a risk of short circuit between the first wire 1421 and the second wire 1422.

The first wire 1421 may be used to transmit the electrical signal between the first component 120 and the second component 130, and the second wire 1422 may be used to form a complete electrical loop. Because the substrate 141 is wide, both the first wire 1421 and the second wire 1422 may be laid flat on the first surface of the substrate 141, and only a single conducting layer is used to transmit the electrical signal between the first component 120 and the second component 130. It can be ensured that the overall structure occupies less space in the height direction of the accommodation space 111.

As shown in FIG. 6, FIG. 7, and FIG. 8, in one or more embodiments, the second conducting layer 144 includes a third wire 1441 and a fourth wire 1442.

The third wire 1441 is fixedly attached to the second surface of the substrate 141. Specifically, the third wire 1441 may be formed by etching the second conducting layer 144. The third wire 1441 is configured to be connected to the first component 120. Specifically, the third wire 1441 is configured to be directly connected to a ground plane of a microstrip close to the first component 120. The substrate 141 has a first opening 1411. The first opening 1411 is a through hole. The first opening 1411 is provided between the second wire 1422 and the third wire 1441. The first opening 1411 may be used to enable the second wire 1422 to be connected to the third wire 1441, so that the third wire 1441 forms a ground plane of the microstrip at an end of the flexible printed circuit board close to the first component 120.

The fourth wire 1442 is fixedly attached to the second surface of the substrate 141. Specifically, the fourth wire 1442 may be formed by etching the second conducting layer 144. The fourth wire 1442 is configured to be connected to the second component 130. Specifically, the fourth wire 1442 is configured to be directly connected to a ground plane of a microstrip close to the second component 130. The substrate 141 has a second opening 1412. The second opening 1412 is a through hole. The second opening 1412 is provided between the second wire 1422 and the fourth wire 1442. The second opening 1412 may be used to enable the second wire 1422 to be connected to the fourth wire 1442, so that the fourth wire 1442 forms a ground plane of the microstrip at an end of the flexible printed circuit board close to the second component 130.

Decapping processing is performed on the second conducting layer 144, so that the second conducting layer 144 only has physical structures at two ends of the flexible printed circuit board, and there is no second conducting layer 144 in a middle region of the flexible printed circuit board. In this case, the third wire 1441 and the fourth wire 1442 both are connected to the second wire 1422. In this way, while it is convenient for the flexible printed circuit board to be connected to the first component 120 and the second component 130 separately, functional integrity of the second conducting layer 144 is also ensured when there are no physical structures in the middle region. Because the middle region of the flexible printed circuit board needs to pass through the accommodation space 111, the second conducting layer 144 does not occupy the accommodation space 111 when there is no second conducting layer 144 in the middle region of the flexible printed circuit board. Therefore, the volume of the accommodation space 111 is effectively ensured.

It should be noted that in specific embodiments of this application, microstrip lines are formed on two ends of the flexible printed circuit board. Certainly, depending on differences between the first component 120 and the second component 130, a microstrip line may be formed on only one end of the flexible printed circuit board, and the other end of the flexible printed circuit board may be a coplanar waveguide or a strip line. For ease of description, an example in which microstrip lines are formed on two ends of the flexible printed circuit board is used as an example.

As shown in FIG. 5, in one or more embodiments, the flexible printed circuit board may further include a first protective film 143.

The first protective film 143 may be of a thin sheet-like flexible structure formed of a plastic film. The first protective film 143 is fixedly attached to a surface of the first conducting layer 142 facing away from the substrate 141 and covers the first conducting layer 142. In other words, the entire first conducting layer 142 is located in clamping space formed by the substrate 141 and the first protective film 143. The first protective film 143 may be used to effectively protect the first conducting layer 142 to prevent the first conducting layer 142 from being damaged and causing an open circuit in some regions. Because the first protective film 143 is also of a thin sheet-like flexible structure, presence of the first protective film 143 does not affect bending, folding, and other processing on the flexible printed circuit board.

Using the first protective film 143 to protect the first conducting layer 142 can prevent the first conducting layer 142 from suffering a risk of open circuit due to damage, and can further prevent the first conducting layer 142 from directly contacting other structures during operation, thereby preventing a risk of short circuit in the first conducting layer 142.

As shown in FIG. 5, in one or more embodiments, the flexible printed circuit board may further include a second protective film 145.

The second protective film 145 may be of a thin sheet-like flexible structure formed of a plastic film. The second protective film 145 is fixedly attached to a surface of the second conducting layer 144 facing away from the substrate 141 and covers the second conducting layer 144. In other words, the entire second conducting layer 144 is located in clamping space formed by the substrate 141 and the second protective film 145. The second protective film 145 may be used to effectively protect the second conducting layer 144 to prevent the second conducting layer 144 from being damaged and causing an open circuit in some regions. Because the second protective film 145 is also of a thin sheet-like flexible structure, presence of the second protective film 145 does not affect bending, folding, and other processing on the flexible printed circuit board.

Using the second protective film 145 to protect the second conducting layer 144 can prevent the second conducting layer 144 from suffering a risk of open circuit due to damage, and can further prevent the second conducting layer 144 from directly contacting other structures during operation, thereby preventing a risk of short circuit in the second conducting layer 144.

As shown in FIG. 5, in one or more embodiments, the second protective film 145 includes a first part 1451 and a second part 1452.

The first part 1451 is fixedly attached to a surface of the third wire 1441 facing away from the substrate 141 and covers the third wire 1441. In other words, the entire third wire 1441 is located in clamping space formed by the substrate 141 and the first part 1451. The first part 1451 may be used to effectively protect the third wire 1441 to prevent the third wire 1441 from being damaged and causing an open circuit in some regions.

The second part 1452 is fixedly attached to a surface of the fourth wire 1442 facing away from the substrate 141 and covers the fourth wire 1442. In other words, the entire fourth wire 1442 is located in clamping space formed by the substrate 141 and the second part 1452. The second part 1452 may be used to effectively protect the fourth wire 1442 to prevent the fourth wire 1442 from being damaged and causing an open circuit in some regions.

Decapping processing is performed on the second protective film 145, so that the second protective film 145 only has physical structures at the two ends of the flexible printed circuit board, and there is no second protective film 145 in the middle region of the flexible printed circuit board. Because the second conducting layer 144 only has the physical structures at the two ends of the flexible printed circuit board, the first part 1451 of the second protective film 145 may be used to protect the third wire 1441 of the second conducting layer 144, and the second part 1452 of the second protective film 145 may be used to protect the fourth wire 1442 of the second conducting layer 144, so that the second protective film 145 can be used to protect the second conducting layer 144. Because the middle region of the flexible printed circuit board needs to pass through the accommodation space 111, the second protective film 145 does not occupy the accommodation space 111 when there is no second protective film 145 in the middle region of the flexible printed circuit board. Therefore, the volume of the accommodation space 111 is effectively ensured.

As shown in FIG. 5, FIG. 6, FIG. 7, and FIG. 8, when there are two conducting layers in the flexible printed circuit board, a thickness of the substrate 141 may be 30 µm to 70 µm. For example, the thickness of the substrate 141 may be 50 µm. The thickness of the first conducting layer 142 may be 8 µm to 20 µm. For example, the thickness of the first conducting layer 142 may be 12 µm. The thickness of the second conducting layer 144 may be 8 µm to 20 µm. For example, the thickness of the second conducting layer 144 may be 12 µm. A thickness of the first protective film 143 may be 20 µm to 50 µm. For example, the thickness of the first protective film 143 may be 27.5 µm. A thickness of the second protective film 145 may be 20 µm to 50 µm. For example, the thickness of the second protective film 145 may be 27.5 µm. In conclusion, a thickness of the entire flexible printed circuit board may be 100 µm to 200 µm. For example, the thickness of the entire flexible printed circuit board may be 127 µm. Because decapping processing may be performed on both the second conducting layer 144 and the second protective film 145 in the middle region of the flexible printed circuit board, in this case, the flexible printed circuit board only occupies a height of the accommodation space 111 by 89.5 µm, while a radio frequency coaxial line used in the conventional technologies needs to occupy a width of the accommodation space 111 by about 1000 µm. In a mobile phone with a general size, when the accommodation space 111 is used for placing a battery 210, according to the solution of this application, capacity of the battery 210 can be increased by 30 mAh to 60 mAh. Specifically, undergoing many tests, when a size of the mobile phone is 6 inches, increased capacity of the battery 210 is about 40 mAh.

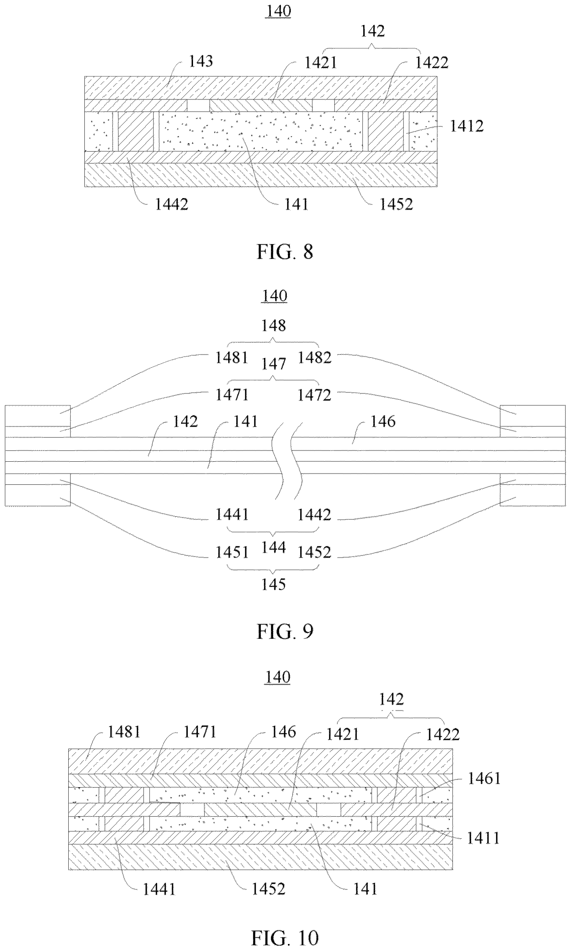

As shown in FIG. 9, FIG. 10, FIG. 11, and FIG. 12, when there are three conducting layers in the flexible printed circuit board, the flexible printed circuit board includes a substrate 141, a first conducting layer 142, a second conducting layer 144, an insulation layer 146, and a third conducting layer 147.

The substrate 141 is of a flexible structure. Specifically, the substrate 141 may be of a thin sheet-like flexible structure formed of a polyimide film or a polyester film. The substrate 141 may withstand relatively large deformations. For example, bending, folding, and other processing may be performed on the substrate 141.

The first conducting layer 142 is fixedly attached to a first surface of the substrate 141. The first conducting layer 142 is configured to be connected to the first component 120 and the second component 130 and transmit an electrical signal between the first component 120 and the second component 130. The first conducting layer 142 may be made of at least one of conductive metals such as copper, silver, and gold, to transmit an electrical signal. Specifically, the first conducting layer 142 may be fixedly attached to the first surface of the substrate 141 through electroplating or other manners. The first conducting layer 142 may form a circuit through etching or other manners. Because a thickness of the first conducting layer 142 is small in the flexible printed circuit board, specifically, the thickness of the first conducting layer 142 may be 8 µm to 20 µm, and the conductive metals such as copper, silver, and gold have good ductility, the entire flexible printed circuit board formed by the substrate 141 and the first conducting layer 142 may also withstand relatively large deformations. For example, bending, folding, and other processing may be performed on the flexible printed circuit board.

The second conducting layer 144 is fixedly attached to a second surface of the substrate 141. To be specific, the second conducting layer 144 is fixedly attached to a surface of the substrate 141 facing away from the first conducting layer 142. The second conducting layer 144 is configured to be connected to the first component 120 and the second component 130 and form an electrical loop together with the first wire 1421. The second conducting layer 144 may be made of at least one of conductive metals such as copper, silver, and gold, to form an electrical loop together with the first wire 1421. Specifically, the second conducting layer 144 may be fixedly attached to the second surface of the substrate 141 through electroplating or other manners. The second conducting layer 144 may form a circuit through etching or other manners. Because a thickness of the second conducting layer 144 is small in the flexible printed circuit board, specifically, the thickness of the second conducting layer 144 may be 8 µm to 20 µm, and the conductive metals such as copper, silver, and gold have good ductility, the entire flexible printed circuit board formed by the substrate 141, the first conducting layer 142, and the second conducting layer 144 may also withstand relatively large deformations. For example, bending, folding, and other processing may be performed on the flexible printed circuit board.

The insulation layer 146 is attached to a surface of the second conducting layer 144 facing away from the substrate 141. The insulation layer 146 is of a flexible structure. Specifically, the insulation layer 146 may be a PI (polyimide) film or a PET (polyethylene terephthalate) film. Because the PI film or the PET film is very thin and flexible, bending, folding, and other processing can be performed on the PI film or the PET film.

The third conducting layer 147 is fixedly attached to a third surface of the insulation layer 146 facing away from the second conducting layer 144. The third conducting layer 147 is configured to be connected to the first component 120 and the second component 130 and form an electrical loop together with the first wire 1421. The third conducting layer 147 may be made of at least one of conductive metals such as copper, silver, and gold, to form an electrical loop together with the first wire 1421. Specifically, the third conducting layer 147 may be fixedly attached to the third surface of the insulation layer 146 through electroplating or other manners. The third conducting layer 147 may form a circuit through etching or other manners. Because a thickness of the third conducting layer 147 is small in the flexible printed circuit board, specifically, the thickness of the third conducting layer 147 may be 8 µm to 20 µm, and the conductive metals such as copper, silver, and gold have good ductility, the entire flexible printed circuit board formed by the substrate 141, the first conducting layer 142, the second conducting layer 144, and the third conducting layer 147 may also withstand relatively large deformations. For example, bending, folding, and other processing may be performed on the flexible printed circuit board.

Using the substrate 141, the first conducting layer 142, the second conducting layer 144, the insulation layer 146, and the third conducting layer 147, a strip line may be formed at an end of the flexible printed circuit board. The first component 120 and the second component 130 in the conventional technologies are generally configured to be connected to a radio frequency coaxial line. The first component 120 and the second component 130 are adaptability modified with respect to the radio frequency coaxial line, and consequently, the first component 120 and the second component 130 are not convenient to be directly connected to a coplanar waveguide. Forming strip lines at two ends of the coplanar waveguide can facilitate connection to the first component 120 and the second component 130.

As shown in FIG. 10, FIG. 11, and FIG. 12, in one or more embodiments, the first conducting layer 142 includes a first wire 1421 and a second wire 1422.

The first wire 1421 is fixedly attached to the first surface of the substrate 141. Specifically, the first wire 1421 may be formed by etching the first conducting layer 142. The first wire 1421 is configured to be connected to the first component 120 and the second component 130 and transmit an electrical signal between the first component 120 and the second component 130. Therefore, the first wire 1421 is in a strip shape, and the first wire 1421 is continuous without interruption between the first component 120 and the second component 130 to ensure that the first wire 1421 may transmit the electrical signal between the first component 120 and the second component 130. Specifically, the first wire 1421 forms a signal line in the strip line at an end of the flexible printed circuit board close to the first component 120.

The second wire 1422 is fixedly attached to the first surface of the substrate 141. Specifically, the second wire 1422 may be formed by etching the first conducting layer 142. The second wire 1422 is configured to be connected to the first component 120 and the second component 130 and form an electrical loop together with the first wire 1421. Therefore, the second wire 1422 is in a strip shape, and the second wire 1422 is continuous without interruption between the first component 120 and the second component 130 to ensure that the second wire 1422 may form an electrical loop between the first component 120 and the second component 130 together with the first wire 1421. The second wire 1422 and the first wire 1421 are spaced apart from each other. To be specific, the first wire 1421 and the second wire 1422 are not in direct contact, to prevent a risk of short circuit between the first wire 1421 and the second wire 1422.

The first wire 1421 may be used to transmit the electrical signal between the first component 120 and the second component 130, and the second wire 1422 may be used to form a complete electrical loop. Because the substrate 141 is wide, both the first wire 1421 and the second wire 1422 may be laid flat on the first surface of the substrate 141, and only a single conducting layer is used to transmit the electrical signal between the first component 120 and the second component 130. It can be ensured that the overall structure occupies less space in the height direction of the accommodation space 111.

As shown in FIG. 10, FIG. 11, and FIG. 12, in one or more embodiments, the second conducting layer 144 includes a third wire 1441 and a fourth wire 1442.

The third wire 1441 is fixedly attached to the second surface of the substrate 141. Specifically, the third wire 1441 may be formed by etching the second conducting layer 144. The third wire 1441 is configured to be connected to the first component 120. Specifically, the third wire 1441 is configured to be directly connected to a ground plane of a strip line close to the first component 120 (because the strip line has two ground planes, upper and lower, in this situation, the third wire may be connected to the upper ground plane of the strip line). The substrate 141 has a first opening 1411. The first opening 1411 is a through hole. The first opening 1411 is provided between the second wire 1422 and the third wire 1441. The first opening 1411 may be used to enable the second wire 1422 to be connected to the third wire 1441, so that the third wire 1441 forms one of the ground planes in the strip line at an end of the flexible printed circuit board close to the first component 120.

The fourth wire 1442 is fixedly attached to the second surface of the substrate 141. Specifically, the fourth wire 1442 may be formed by etching the second conducting layer 144. The fourth wire 1442 is configured to be connected to the second component 130. Specifically, the fourth wire 1442 is configured to be directly connected to a ground plane of a strip line close to the second component 130 (because the strip line has two ground planes, upper and lower, in this situation, the fourth wire may be connected to the upper ground plane of the strip line). The substrate 141 has a second opening 1412. The second opening 1412 is a through hole. The second opening 1412 is provided between the second wire 1422 and the fourth wire 1442. The second opening 1412 may be used to enable the second wire 1422 to be connected to the fourth wire 1442, so that the fourth wire 1442 forms one of the ground planes in the strip line at an end of the flexible printed circuit board close to the second component 130.

Decapping processing is performed on the second conducting layer 144, so that the second conducting layer 144 only has physical structures at two ends of the flexible printed circuit board, and there is no second conducting layer 144 in a middle region of the flexible printed circuit board. In this case, the third wire 1441 and the fourth wire 1442 both are connected to the second wire 1422. In this way, while it is convenient for the flexible printed circuit board to be connected to the first component 120 and the second component 130 separately, functional integrity of the second conducting layer 144 is also ensured when there are no physical structures in the middle region. Because the middle region of the flexible printed circuit board needs to pass through the accommodation space 111, the second conducting layer 144 does not occupy the accommodation space 111 when there is no second conducting layer 144 in the middle region of the flexible printed circuit board. Therefore, the volume of the accommodation space 111 is effectively ensured.

As shown in FIG. 10, FIG. 11, and FIG. 12, in one or more embodiments, the third conducting layer 147 includes a fifth wire 1471 and a sixth wire 1472.

The fifth wire 1471 is fixedly attached to the third surface of the insulation layer 146. Specifically, the fifth wire 1471 may be formed by etching the third conducting layer 147. The fifth wire 1471 is configured to be connected to the first component 120. Specifically, the fifth wire 1471 is configured to be directly connected to a ground plane of a strip line close to the first component 120 (because the strip line has two ground planes, upper and lower, in this situation, the fifth wire may be connected to the lower ground plane of the strip line). The insulation layer 146 has a third opening 1461. The third opening 1461 is a through hole. The third opening 1461 is provided between the second wire 1422 and the fifth wire 1471. The third opening 1461 may be used to enable the second wire 1422 to be connected to the fifth wire 1471, so that the fifth wire 1471 forms the other ground plane in the strip line at an end of the flexible printed circuit board close to the first component 120.

The sixth wire 1472 is fixedly attached to the third surface of the insulation layer 146. Specifically, the sixth wire 1472 may be formed by etching the third conducting layer 147. The sixth wire 1472 is configured to be connected to the second component 130. Specifically, the sixth wire 1472 is configured to be directly connected to a ground plane of a strip line close to the second component 130 (because the strip line has two ground planes, upper and lower, in this situation, the sixth wire may be connected to the lower ground plane of the strip line). The insulation layer 146 has a fourth opening 1462. The fourth opening 1462 is a through hole. The fourth opening 1462 is provided between the second wire 1422 and the sixth wire 1472. The fourth opening 1462 may be used to enable the second wire 1422 to be connected to the sixth wire 1472, so that the sixth wire 1472 forms the other ground plane in the strip line at an end of the flexible printed circuit board close to the second component 130.

Decapping processing is performed on the third conducting layer 147, so that the third conducting layer 147 only has physical structures at two ends of the flexible printed circuit board, and there is no third conducting layer 147 in a middle region of the flexible printed circuit board. In this case, the fifth wire 1471 and the sixth wire 1472 both are connected to the second wire 1422. In this way, while it is convenient for the flexible printed circuit board to be connected to the first component 120 and the second component 130 separately, functional integrity of the third conducting layer 147 is also ensured when there are no physical structures in the middle region. Because the middle region of the flexible printed circuit board needs to pass through the accommodation space 111, the third conducting layer 147 does not occupy the accommodation space 111 when there is no third conducting layer 147 in the middle region of the flexible printed circuit board. Therefore, the volume of the accommodation space 111 is effectively ensured.

As shown in FIG. 9, FIG. 10, FIG. 11, and FIG. 12, in one or more embodiments, the flexible printed circuit board may further include a second protective film 145.

The second protective film 145 may be of a thin sheet-like flexible structure formed of a plastic film. The second protective film 145 is fixedly attached to a surface of the second conducting layer 144 facing away from the substrate 141 and covers the second conducting layer 144. In other words, the entire second conducting layer 144 is located in clamping space formed by the substrate 141 and the second protective film 145. The second protective film 145 may be used to effectively protect the second conducting layer 144 to prevent the second conducting layer 144 from being damaged and causing an open circuit in some regions. Because the second protective film 145 is also of a thin sheet-like flexible structure, presence of the second protective film 145 does not affect bending, folding, and other processing on the flexible printed circuit board.

Using the second protective film 145 to protect the second conducting layer 144 can prevent the second conducting layer 144 from suffering a risk of open circuit due to damage, and can further prevent the second conducting layer 144 from directly contacting other structures during operation, thereby preventing a risk of short circuit in the second conducting layer 144.

As shown in FIG. 9, in one or more embodiments, the second protective film 145 includes a first part 1451 and a second part 1452.

The first part 1451 is fixedly attached to a surface of the third wire 1441 facing away from the substrate 141 and covers the third wire 1441. In other words, the entire third wire 1441 is located in clamping space formed by the substrate 141 and the first part 1451. The first part 1451 may be used to effectively protect the third wire 1441 to prevent the third wire 1441 from being damaged and causing an open circuit in some regions.

The second part 1452 is fixedly attached to a surface of the fourth wire 1442 facing away from the substrate 141 and covers the fourth wire 1442. In other words, the entire fourth wire 1442 is located in clamping space formed by the substrate 141 and the second part 1452. The second part 1452 may be used to effectively protect the fourth wire 1442 to prevent the fourth wire 1442 from being damaged and causing an open circuit in some regions.

Decapping processing is performed on the second protective film 145, so that the second protective film 145 only has physical structures at the two ends of the flexible printed circuit board, and there is no second protective film 145 in the middle region of the flexible printed circuit board. Because the second conducting layer 144 only has the physical structures at the two ends of the flexible printed circuit board, the first part 1451 of the second protective film 145 may be used to protect the third wire 1441 of the second conducting layer 144, and the second part 1452 of the second protective film 145 may be used to protect the fourth wire 1442 of the second conducting layer 144, so that the second protective film 145 can be used to protect the second conducting layer 144. Because the middle region of the flexible printed circuit board needs to pass through the accommodation space 111, the second protective film 145 does not occupy the accommodation space 111 when there is no second protective film 145 in the middle region of the flexible printed circuit board. Therefore, the volume of the accommodation space 111 is effectively ensured.

As shown in FIG. 9, in one or more embodiments, the flexible printed circuit board may further include a third protective film 148.

The third protective film 148 may be of a thin sheet-like flexible structure formed of a plastic film. The third protective film 148 is fixedly attached to a surface of the third conducting layer 147 facing away from the insulation layer 146 and covers the third conducting layer 147. In other words, the entire third conducting layer 147 is located in clamping space formed by the insulation layer 146 and the third protective film 148. The third protective film 148 may be used to effectively protect the third conducting layer 147 to prevent the third conducting layer 147 from being damaged and causing an open circuit in some regions. Because the third protective film 148 is also of a thin sheet-like flexible structure, presence of the third protective film 148 does not affect bending, folding, and other processing on the flexible printed circuit board.

Using the third protective film 148 to protect the third conducting layer 147 can prevent the third conducting layer 147 from suffering a risk of open circuit due to damage, and can further prevent the third conducting layer 147 from directly contacting other structures during operation, thereby preventing a risk of short circuit in the third conducting layer 147.

As shown in FIG. 9, FIG. 10, FIG. 11, and FIG. 12, when there are three conducting layers in the flexible printed circuit board, a thickness of the substrate 141 may be 8 µm to 20 µm. For example, the thickness of the substrate 141 may be 12 µm. The thickness of the first conducting layer 142 may be 8 µm to 20 µm. For example, the thickness of the first conducting layer 142 may be 12 µm. The thickness of the second conducting layer 144 may be 8 µm to 20 µm. For example, the thickness of the second conducting layer 144 may be 12 µm. A thickness of the insulation layer 146 may be 15 µm to 40 µm. For example, the thickness of the insulation layer 146 may be 25 µm. A thickness of the third conducting layer 147 may be 8 µm to 20 µm. For example, the thickness of the third conducting layer 147 may be 12 µm. A thickness of the second protective film 145 may be 20 µm to 50 µm. For example, the thickness of the second protective film 145 may be 27.5 µm. A thickness of the third protective film 148 may be 20 µm to 50 µm. For example, the thickness of the third protective film 148 may be 27.5 µm. In conclusion, a thickness of the entire flexible printed circuit board may be 100 µm to 200 µm. For example, the thickness of the entire flexible printed circuit board may be 128 µm. Because decapping processing may be performed on the second conducting layer 144 in the middle region of the flexible printed circuit board, in this case, the flexible printed circuit board only occupies a height of the accommodation space 111 by 76.5 µm, while a radio frequency coaxial line used in the conventional technologies needs to occupy a width of the accommodation space 111 by about 1000 µm. In a mobile phone with a general size, when the accommodation space 111 is used for placing a battery 210, according to the solution of this application, capacity of the battery 210 can be increased by 30 mAh to 60 mAh. Specifically, undergoing many tests, when a size of the mobile phone is 6 inches, increased capacity of the battery 210 is about 40 mAh.

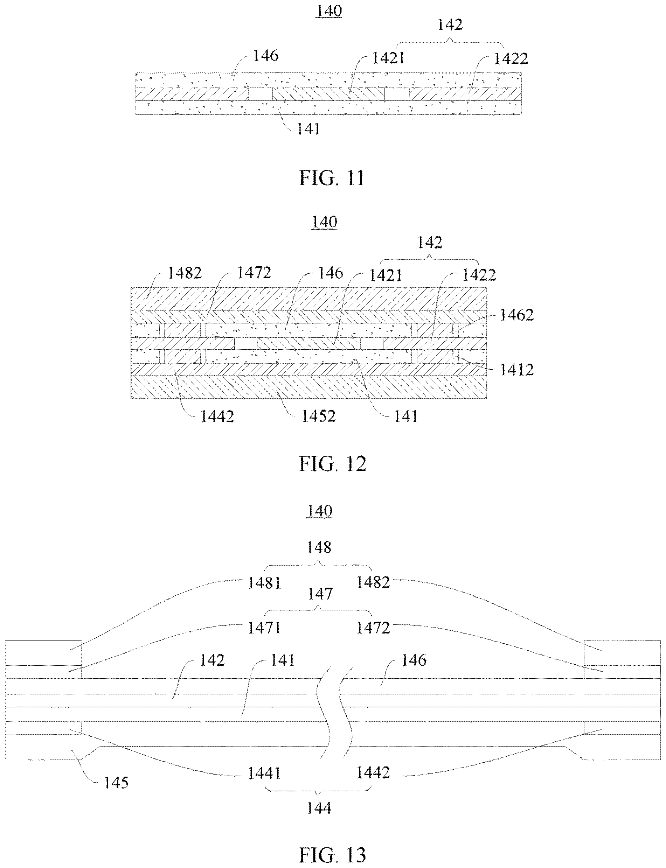

As shown in FIG. 13, in one or more embodiments, the third protective film 148 includes a third part 1481 and a fourth part 1482.

The third part 1481 is fixedly attached to a surface of the fifth wire 1471 facing away from the insulation layer 146 and covers the fifth wire 1471. In other words, the entire fifth wire 1471 is located in clamping space formed by the insulation layer 146 and the third part 1481. The third part 1481 may be used to effectively protect the fifth wire 1471 to prevent the fifth wire 1471 from being damaged and causing an open circuit in some regions.

The fourth part 1482 is fixedly attached to a surface of the sixth wire 1472 facing away from the insulation layer 146 and covers the sixth wire 1472. In other words, the entire sixth wire 1472 is located in clamping space formed by the insulation layer 146 and the fourth part 1482. The fourth part 1482 may be used to effectively protect the sixth wire 1472 to prevent the sixth wire 1472 from being damaged and causing an open circuit in some regions.

Decapping processing is performed on the third protective film 148, so that the third protective film 148 only has physical structures at the two ends of the flexible printed circuit board, and there is no third protective film 148 in the middle region of the flexible printed circuit board. Because the third conducting layer 147 only has the physical structures at the two ends of the flexible printed circuit board, the third part 1481 of the third protective film 148 may be used to protect the fifth wire 1471 of the third conducting layer 147, and the fourth part 1482 of the third protective film 148 may be used to protect the sixth wire 1472 of the third conducting layer 147, so that the third protective film 148 can be used to protect the third conducting layer 147. Because the middle region of the flexible printed circuit board needs to pass through the accommodation space 111, the third protective film 148 does not occupy the accommodation space 111 when there is no third protective film 148 in the middle region of the flexible printed circuit board. Therefore, the volume of the accommodation space 111 is effectively ensured.

As shown in FIG. 13, FIG. 14, FIG. 15, and FIG. 16, when there are three conducting layers in the flexible printed circuit board, a thickness of the substrate 141 may be 8 µm to 20 µm. For example, the thickness of the substrate 141 may be 12 µm. The thickness of the first conducting layer 142 may be 8 µm to 20 µm. For example, the thickness of the first conducting layer 142 may be 12 µm. The thickness of the second conducting layer 144 may be 8 µm to 20 µm. For example, the thickness of the second conducting layer 144 may be 12 µm. A thickness of the insulation layer 146 may be 15 µm to 40 µm. For example, the thickness of the insulation layer 146 may be 25 µm. A thickness of the third conducting layer 147 may be 8 µm to 20 µm. For example, the thickness of the third conducting layer 147 may be 12 µm. A thickness of the second protective film 145 may be 20 µm to 50 µm. For example, the thickness of the second protective film 145 may be 27.5 µm. A thickness of the third protective film 148 may be 20 µm to 50 µm. For example, the thickness of the third protective film 148 may be 27.5 µm. In conclusion, a thickness of the entire flexible printed circuit board may be 100 µm to 200 µm. For example, the thickness of the entire flexible printed circuit board may be 128 µm. Because decapping processing may be performed on both the second conducting layer 144 and the second protective film 145 in the middle region of the flexible printed circuit board, in this case, the flexible printed circuit board only occupies a height of the accommodation space 111 by 49 µm, while a radio frequency coaxial line used in the conventional technologies needs to occupy a width of the accommodation space 111 by about 1000 µm. In a mobile phone with a general size, when the accommodation space 111 is used for placing a battery 210, according to the solution of this application, capacity of the battery 210 can be increased by 30 mAh to 60 mAh. Specifically, undergoing many tests, when a size of the mobile phone is 6 inches, increased capacity of the battery 210 is about 50 mAh.

In one or more embodiments, the connecting member 140 is configured to transmit a radio frequency signal between the first component 120 and the second component 130. Specifically, when the first component 120 is configured to achieve a connection between an antenna module and a transmission link on a structural member, for example, the first component 120 is of a structure such as an antenna spring, a radio frequency signal may be transmitted between the first component 120 and the second component 130. In this case, a part of the flexible printed circuit board adhered to a bottom wall forms a coplanar waveguide. For the radio frequency signal, the use of the coplanar waveguide for transmission can effectively reduce insertion loss to ensure a transmission effect of the radio frequency signal.

Undergoing many experiments, it has been confirmed that compared with the entire connecting member 140 being a microstrip or a strip line, a part of the connecting member 140 in the accommodation space 111 uses a flexible printed circuit board and forms a coplanar waveguide, reducing the insertion loss by about 42%.

As shown in FIG. 1 and FIG. 2, in one or more embodiments, the electronic assembly 100 further includes a reinforcement member 150.

The reinforcement member 150 is of a rigid structure. Specifically, the reinforcement member 150 may be of a structure such as a rigid plastic. For example, the reinforcement member 150 may be bakelite or the like. The reinforcement member 150 is fixedly connected to the first component 120. Specifically, the reinforcement member 150 may be fixedly connected to the first component 120 through welding, bonding, or another manner, or may be fixedly connected to the first component 120 through a screw, a clip, or another structure. Because the screw, the clip, and another structure occupy an amount of space, preferably the reinforcement member 150 is fixedly connected to the first component 120 through welding, bonding, or another manner. The reinforcement member 150 is also fixedly connected to a part of the connecting member 140 close to the first component 120. Specifically, the reinforcement member 150 may be fixedly connected to the connecting member 140 through welding, bonding, or another manner, or may be fixedly connected to the connecting member 140 through a screw, a clip, or another structure. Because the screw, the clip, and another structure occupy an amount of space, preferably the reinforcement member 150 is fixedly connected to the connecting member 140 through welding, bonding, or another manner. Specifically, the reinforcement member 150 may be of an insulation structure to prevent leakage of electricity when the reinforcement member 150 is connected to a structure such as a metal housing.

At a connection part between the connecting member 140 and the first component 120, due to a small thickness of the flexible printed circuit board, it is difficult to fix the flexible printed circuit board on a structure such as the housing 110. Consequently, the connecting member 140 and the first component 120 are caused to be easily disconnected by external forces such as impact. The use of reinforcement member 150 can keep a positional relationship between the connecting member 140 and the first component 120 stable at the connection part, thereby improving impact resistance of the overall structure.

In one or more embodiments, the reinforcement member 150 may be fixedly connected to a structure with high structural strength such as the housing 110. Specifically, because the structural strength of the structure such as the housing 110 is high, the structure such as the housing 110 deforms slighter under action of external force, so that the smaller external force is transmitted to the reinforcement member 150 to protect the reinforcement member 150, thereby effectively ensuring stability of the connection between the first component 120 and the connecting member 140.

In one or more embodiments, the first component 120 is an antenna spring. In this case, the first component 120 is arranged to adhere to the housing 110, so that the connecting member 140 is difficult to bypass the accommodation space 111, the first component 120 can receive and/or transmit a radio frequency signal, and using a sheet-shaped connecting member 140 can facilitate formation of a coplanar waveguide to reduce insertion loss of the radio frequency signal during transmission. Certainly, in other embodiments, the first component 120 may alternatively be a volume adjustment component or another component that adheres to the housing 110 and needs to transmit a signal to other structures.

In one or more embodiments, the second component 130 is a main board. In this case, the second component 130 is connected to the first component 120. When the first component 120 is configured to receive a signal, the second component 130 may process the signal received by the first component 120. When the first component 120 is configured to transmit a signal, the second component 130 may control the first component 120 to transmit the signal.

In one or more embodiments, the accommodation space 111 is configured to accommodate the battery 210. Because in an electronic device, a size of the battery 210 is directly related to the amount of power, and standby time of the electronic device such as a mobile phone is closely related to user experience, when the accommodation space 111 is configured to accommodate the battery 210, according to the solution of this application, the volume of the battery 210 can be effectively increased, thereby effectively increasing the power of the battery 210, and significantly improving the user experience.

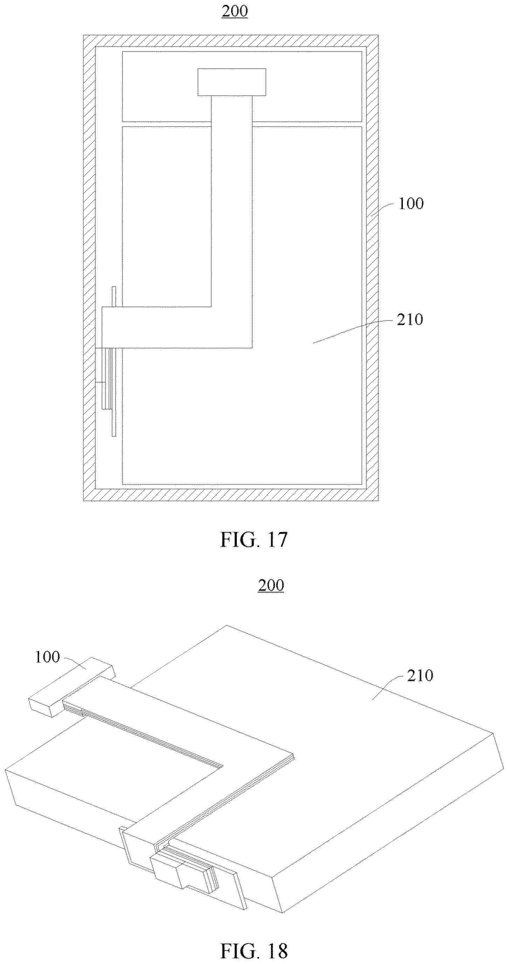

As shown in FIG. 17 and FIG. 18, in one or more embodiments, this application further provides a terminal device 200. The terminal device 200 includes the foregoing electronic assembly 100.

The terminal device 200 may be a mobile phone, a tablet computer, an e-reader, a wearable device, a laptop, a personal digital assistant (personal digital assistant, PDA), or the like. Because the foregoing electronic assembly 100 can effectively increase the volume of the accommodation space 111, the terminal device 200 can accommodate an electronic component having a larger volume without changing a size of the housing 110, thereby effectively improving performance of the terminal device 200.

As shown in FIG. 17 and FIG. 18, in one or more embodiments, the terminal device 200 further includes a battery 210.

The battery 210 may be a ternary lithium battery 210 that is currently commonly used, or may be a lithium iron phosphate battery 210 or another battery 210. The battery 210 is accommodated in the accommodation space 111. Specifically, the battery 210 may be directly placed in the accommodation space 111, may be fixedly bonded in the accommodation space 111 through glue or another manner, or may be engaged in the accommodation space 111 through a clip or another structure.

A surface of the connecting member 140 facing away from the first surface is attached to the battery 210. In other words, the connecting member 140 is clamped between the battery 210 and a side wall of the accommodation space 111. Because the connecting member 140 is in a sheet shape, the connecting member 140 less occupies the battery 210 and the accommodation space 111, so that a volume of the battery 210 can be increased and standby time of the terminal device 200 is effectively increased.

In the descriptions of this specification of this application, the specific features, structures, materials, or characteristics may be combined in a proper manner in any one or more of the embodiments or examples.

Finally, it should be noted that the foregoing embodiments are merely intended for describing the technical solutions of this application, but not for limiting this application. Although this application are described in detail with reference to the foregoing embodiments, a person of ordinary skill in the art should understand that modifications may still be made to the technical solutions described in the foregoing embodiments, or equivalent replacements may be made to the part of the technical features; and these modifications or replacements will not cause the essence of corresponding technical solutions to depart from the spirit and scope of the technical solutions in embodiments of this application.

## Claims

1. An electronic assembly, comprising:
a housing, forming a first side wall, a second side wall, and a bottom wall, wherein the first side wall, the second side wall, and the bottom wall jointly form accommodation space;
a first component, disposed on the first side wall;
a second component, disposed on the second side wall; and
a connecting member, wherein one end of the connecting member is connected to the first component, the other end of the connecting member passes through the accommodation space to be connected to the second component, the connecting member is in a sheet shape, and a thickness of at least one end of the connecting member is greater than a thickness of a middle region between two ends of the connecting member.

2. The electronic assembly according to claim 1, wherein the two ends of the connecting member are provided with a plurality of conducting layers, and the middle region between the two ends of the connecting member is provided with one conducting layer.

3. The electronic assembly according to claim 2, wherein at least part of the connecting member is a flexible printed circuit board, the flexible printed circuit board forms a first surface, a surface of the connecting member having a larger area is the first surface, one end of the flexible printed circuit board is a first end, and the other end of the flexible printed circuit board is a second end.

4. The electronic assembly according to claim 3, wherein the first end and the second end are respectively the two ends of the connecting member;
the first end of the flexible printed circuit board forms a microstrip or a strip line, and the second end of the flexible printed circuit board forms a coplanar waveguide, a microstrip, or a strip line; and
the middle region between the first end and the second end forms a coplanar waveguide.

5. The electronic assembly according to claim 3 or 4, wherein the flexible printed circuit board comprises:
a substrate that is of a flexible structure; and
a first conducting layer, fixedly attached to a first surface of the substrate, and configured to be connected to the first component and the second component and transmit an electrical signal between the first component and the second component.

6. The electronic assembly according to claim 5, wherein the first conducting layer comprises
a first wire, fixedly attached to the first surface of the substrate, and configured to be connected to the first component and the second component and transmit an electrical signal between the first component and the second component; and
a second wire, fixedly attached to the first surface of the substrate, and configured to be connected to the first component and the second component and form an electrical loop together with the first wire, wherein the second wire and the first wire are spaced apart from each other.

7. The electronic assembly according to claim 5, wherein the flexible printed circuit board further comprises:
a first protective film, fixedly attached to a surface of the first conducting layer facing away from the substrate, and covering the first conducting layer.

8. The electronic assembly according to claim 6, wherein a part of the second wire in the middle region forms a coplanar waveguide with a part of the first wire in the middle region.

9. The electronic assembly according to claim 6, wherein the flexible printed circuit board further comprises:
a second conducting layer, located at the first end and the second end, fixedly attached to a second surface of the substrate facing away from the first conducting layer, configured to be connected to the first component and the second component and form an electrical loop together with the first wire.

10. The electronic assembly according to claim 9, wherein the second conducting layer comprises:
a third wire, fixedly attached to the second surface of the substrate, disposed on one end of the flexible printed circuit board close to the first component, and configured to be connected to the first component, wherein the substrate has a first opening, and the third wire passes through the first opening to be connected to the second wire; and
a fourth wire, fixedly attached to the second surface of the substrate, disposed on one end of the flexible printed circuit board close to the second component, and configured to be connected to the second component, wherein the substrate has a second opening, and the fourth wire passes through the second opening to be connected to the second wire.

11. The electronic assembly according to claim 10, wherein a part of the first wire located at the first end forms a microstrip or a strip line with the third wire; and
a part of the first wire located at the second end forms a microstrip or a strip line with the fourth wire.

12. The electronic assembly according to claim 10, wherein the flexible printed circuit board further comprises:
a second protective film, fixedly attached to a surface of the second conducting layer facing away from the substrate, and covering the second conducting layer.

13. The electronic assembly according to claim 12, wherein the second protective film comprises:
a first part, fixedly attached to a surface of the third wire facing away from the substrate, and covering the third wire; and
a second part, fixedly attached to a surface of the fourth wire facing away from the substrate, and covering the fourth wire.

14. The electronic assembly according to claim 10, wherein the flexible printed circuit board further comprises:
an insulation layer, fixedly attached to a surface of the first conducting layer facing away from the substrate; and
a third conducting layer, located at the first end and the second end, fixedly attached to a third surface of the insulation layer facing away from the first conducting layer, configured to be connected to the first component and the second component, and forming an electrical loop together with the first wire.

15. The electronic assembly according to claim 14, wherein the third conducting layer comprises:
a fifth wire, fixedly attached to a third surface of the insulation layer, disposed on one end of the flexible printed circuit board close to the first component, and configured to be connected to the first component, wherein the insulation layer has a third opening, and the fifth wire passes through the third opening to be connected to the second wire; and
a sixth wire, fixedly attached to the third surface of the insulation layer, disposed on one end of the flexible printed circuit board close to the second component, and configured to be connected to the second component, wherein the insulation layer has a fourth opening, and the sixth wire passes through the fourth opening to be connected to the second wire.

16. The electronic assembly according to claim 15, wherein a part of the first wire located at the first end forms a microstrip or a strip line with the third wire and the fifth wire; and a part of the first wire located at the second end forms a microstrip or a strip line with the fourth wire and the sixth wire.

17. The electronic assembly according to claim 15, wherein the flexible printed circuit board further comprises:
a third protective film, fixedly attached to a surface of the third conducting layer facing away from the substrate, and covering the third conducting layer.

18. The electronic assembly according to claim 17, wherein the third protective film comprises:
a third part, fixedly attached to a surface of the fifth wire facing away from the insulation layer, and covering the fifth wire; and
a second part, fixedly attached to a surface of the sixth wire facing away from the insulation layer, and covering the sixth wire.

19. The electronic assembly according to any one of claims 1 to 4, further comprising:
a reinforcement member that is of a rigid structure and fixedly connected to a part of the connecting member close to the first component.

20. A terminal device,
comprising the electronic assembly according to any one of claims 1 to 19.

21. The terminal device according to claim 20, further comprising:
a battery, accommodated in the accommodation space, wherein a surface of the connecting member having a larger area is the first surface, and a part of the first surface located in the accommodation space is attached to the bottom wall; and
a surface of the connecting member facing away from the first surface is attached to the battery.
